# EUROPEAN PATENT APPLICATION

(11) **EP 4 398 293 A1**
(43) Date of publication of application: **10.07.2024**
(21) Application number: 23217754.3
(22) Date of filing: 18.12.2023
(51) Int. Cl.: H01L 23/15, H01L 23/31, H01L 23/498, H01L 23/538

(54) **HIGH FREQUENCY DEVICE PACKAGES**

(30) Priority: 21.12.2022 US 202263476595 P
(71) Applicant: Analog Devices, Inc., Wilmington, MA 01887 (US)
(72) Inventor: Kudtarkar, Santosh Anil, Wilmington 01887 (US); Raj, Arun, Wilmington 01887 (US); Vidyarthy, Sharad, Wilmington 01887 (US); Goida, Thomas M., Wilmington 01887 (US)
(74) Representative: Wallin, Nicholas James

(57) **Abstract**

An integrated device package may include a glass interposer having one or more conductive vias extending through the glass interposer from a top side of the glass interposer to a bottom side of the glass interposer, the bottom side of the glass interposer comprising one or more contact pads. The device package may include an integrated device die mounted and electrically connected to the top side of the glass interposer. The device package may also include an encapsulating material disposed over at least a side surface of the glass interposer, a portion of the top surface of the glass interposer, and a side surface of the integrated device die.

## Description

### BACKGROUND

### Technical Field

The field relates to high frequency device packages, and, in particular, to packages that utilize an interposer that provides high signal quality.

### Description of the Related Art

High frequency integrated device packages have a number of applications in consumer electronics, aeronautics, and many other industries. However, with conventional packages, it can be challenging to provide a package that operates at high frequencies without substantial signal losses. Accordingly, there remains a continuing need for improved high frequency device packages.

### SUMMARY

In some aspects, the techniques described herein relate to an integrated device package including a glass interposer having one or more conductive vias extending through the glass interposer from a top side of the glass interposer to a bottom side of the glass interposer, the bottom side of the glass interposer including one or more contact pads, an integrated device die mounted and electrically connected to the top side of the glass interposer and an encapsulating material disposed over at least a side surface of the glass interposer, a portion of the top surface of the glass interposer, and a side surface of the integrated device die.

In some aspects, the techniques described herein relate to an integrated device package including: an interposer having one or more conductive vias extending through the interposer from a top side of the interposer to a bottom side of the interposer, the interposer including one or more passive devices configured to serve as a first electrical filter; and an integrated device die mounted and electrically connected to the top side of the glass interposer, the integrated device die including circuitry configured to serve as a second electrical filter.

### BRIEF DESCRIPTION OF THE DRAWINGS

Figures 1A-1B are schematic diagrams of an integrated device package according to one embodiment;
Figures 2A-2B are schematic diagrams of an integrated device package according to an additional embodiment;
Figures 3A-3B are schematic diagrams of an integrated device package according to another embodiment;
Figures 4A-4C are schematic diagrams of an integrated device package according to yet another embodiment; and
Figure 4D illustrates a patterned metal layer of an insulating substrate according to any of the Figures 4A-4C.

### DETAILED DESCRIPTION

High frequency integrated device packages can include a package substrate and an integrated device die mounted to the packager substrate. In high frequency applications, the die can be configured to operate at high frequencies, e.g., at frequencies of 0.6 GHz or greater, 10 GHz or greater, or 50 GHz or greater. For example, high frequency integrated device dies can operate at one or more operational frequencies in a range of 0.6 GHz to 150 GHz, or in a range of 0.6 GHz to 120 GHz. The dies are typically mounted to a laminate substrate (such as a printed circuit board, or PCB) by way of solder balls. The use of PCB materials in combination with solder balls introduces electrical signal losses for high frequency applications.

Accordingly, in various embodiments disclosed herein, a high frequency integrated device package can utilize an interposer (also referred to herein as a substrate) formed of a material that reduces or minimizes signal losses for dies that operate at high frequencies. In various embodiments, the interposer can be composed of a glass material (*e.g.*, a borosilicate glass or any other suitable glass) that has low signal losses at high frequencies. Although the illustrated embodiments show a glass interposer or substrate, other materials may be suitable, for example, materials that have a low dielectric constant. For example, in some embodiments, the interposer or substrate can have a loss tangent of less than 0.02 at 10 GHz and 20 GHz die operating frequencies. In various embodiments, the interposer or substrate can serve as a passthrough element without active or passive circuitry. In other embodiments, the interposer or substrate can comprise one or more passive devices patterned or formed therein, *e.g.*, one or more inductors, capacitors, etc. The passive devices in the interposer can serve as a filter element in various embodiments. The illustrated embodiments can be encapsulated with an encapsulating material (such as a polymer or epoxy resin) and can comprise land grid array (LGA) or ball grid array (BGA) packages. In various embodiments, the encapsulating material can comprise an organic encapsulant (such as an epoxy resin) or an inorganic encapsulant.

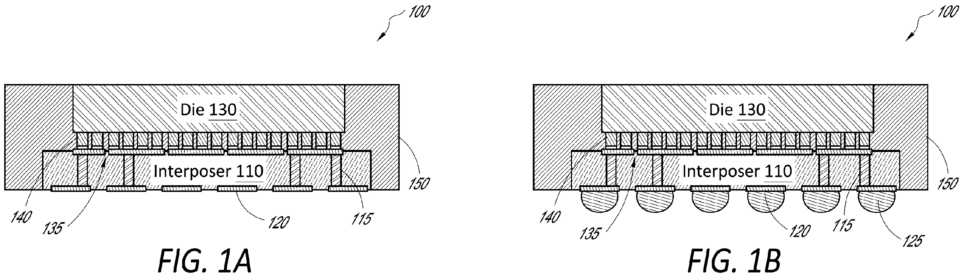

Figures 1A-4D illustrate examples of integrated device packages according to various embodiments. As shown in Figures 1A-1B, a device package 100 can comprise an interposer 110 having one or more conductive vias 115 extending through the interposer from a top side of the interposer to a bottom side of the interposer. The bottom side of the interposer 110 can have one or more contact pads 120. In Figure 1B, one or more solder balls 125 can be provided on the contact pads 120 on the bottom side of the interposer 110. The solder balls 125 can be configured to connect to another device, such as a system board (e.g., printed circuit board) or other substrate. As shown in Figures 1A-1B, an integrated device die 130 can be mounted and electrically connected to the top side of the glass interposer 110. For example, in the illustrated embodiment, bond pads of the die (not shown) can connect to corresponding pads 135 on the top side of the interposer 110 by way of a plurality of conductive interconnects 140. The interconnects 140 can comprise any suitable type of electrical interconnect, such as solder bumps (e.g., lead, tin-lead, lead free solder, etc.). In some embodiments, the interconnects 140 can comprise copper pillars, which may be capped with solder bumps. In some embodiments, the die 130 can be a flip chip die bonded to the interposer 110 in a gold bump flip chip process.

The integrated device die 130 can comprise any suitable type of device die, such as a processor die or a radio frequency device die. The die 130 can be configured to operate at high frequencies, *e.g.*, one or more operational frequencies in a range of 0.6 GHz to 250 GHz, or in some embodiments, in a range of 0.6 GHz to 120 GHz. The die 130 can be formed of any suitable type of semiconductor material. For example, the die can comprise silicon, silicon germanium, gallium arsenide, gallium nitride, or any other suitable semiconductor material. The die can be provided with or without backside vias.

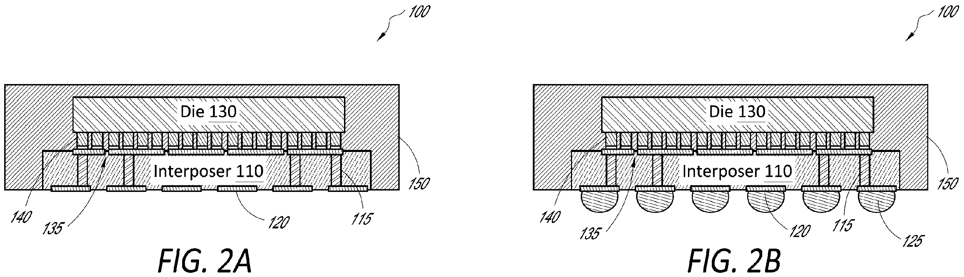

As shown in Figures 1A-1B, an encapsulating material 150 can be disposed over at least a side surface of the glass interposer 110, a portion of the top surface of the glass interposer 110, and a side surface of the integrated device die 130. In Figures 1A-1B, a top side of the integrated device die 130 is exposed through the encapsulating material 150. By contrast, in Figures 2A-2B, the encapsulating material 150 is disposed over a top side of the integrated device die 130, such that the die is completely embedded in the encapsulating material. In certain embodiments, the encapsulating material 150 may be an overmold formed over the top side of the integrated device die 130 An excess portion of the overmold can be removed (e.g., by grinding or laser ablation) to achieve the desired thickness and provide a planar exterior surface of the device package 100. Thus, as shown in Figures 1A-2B, both the glass interposer 110 and the integrated device die 130 can be at least partially embedded in the encapsulating material 150. The encapsulating material can accordingly protect both the die 130 and the interposer 110 in the illustrated embodiments. The encapsulating material 150 in the illustrated embodiments can comprise an organic molding compound (e.g., epoxy resin). In other embodiments, other types of protective encapsulating materials can be used.

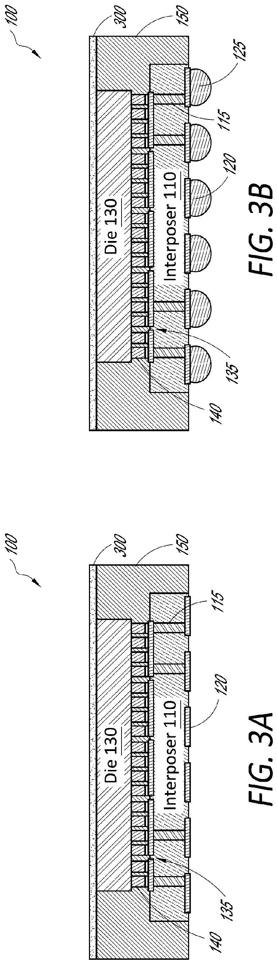

The embodiment of Figures 1A-1B may be preferred in certain applications for improved heat dissipation by the exposed die. Similarly, turning to Figures 3A-3B, in some embodiments, a heat slug 300 can be disposed on the exposed top side of the die 130 and on an upper surface of the encapsulating material 150. The heat slug 300 can comprise a thermally conductive material, such as a metal (*e.g.*, copper) or a thermally conductive dielectric. The heat slug 300 can be mounted (for example, with an adhesive or thermal interface material) or deposited onto the die 130 and encapsulating material 150. Beneficially, the heat slug 300 can be configured to convey heat away from the integrated device die 130. In some embodiments, a separate heat sink (*e.g.*, a finned heat sink) can be provided on the heat slug 300. In other embodiments, a thermoelectric cooler (TEC) or any other cooling device known to those skilled in the art can be provided on the heat slug 300.

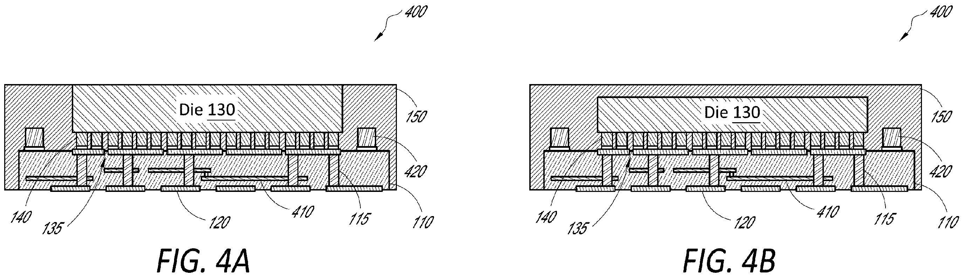

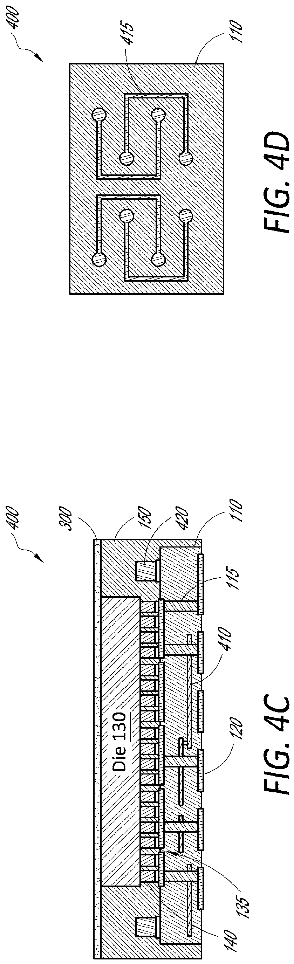

Figures 4A-4C illustrate integrated device packages 400 that may be generally similar to the integrated device packages 100 of Figures 1A-3B. However, in Figures 4A-4C, the interposer 110 comprises one or more passive devices 410 formed in one or more layers of the interposer. For example, in some embodiments, the interposer 110 can be patterned with cavities, and a patterned metal 415 (*e.g.*, copper, aluminum, etc.) can be provided in the patterned cavities. As shown in Figure 4D (a schematic top plan view), the patterned metal 415 in one or more layers of the insulating substrate 110 can serve as any suitable passive electronic device 410 , *e.g.*, an inductor, a capacitor, a resistor, etc.

In some embodiments, the passive device 410 in the interposer or substrate 110 can serve as an electrical filter, to pass or block signals at certain frequency ranges. In some embodiments, for example, the interposer 110 can be configured to serve as a first electrical filter, and the integrated device die 130 can comprise circuitry configured to serve as a second electrical filter. The first electrical filter can comprise a high pass filter, and the second electrical filter can comprise a low pass filter, or vice versa.

Further, as shown in Figures 4A-4C, one or more passive electronic components 420 can be mounted to the glass interposer 110. The passive electronic components 420 can comprise any suitable type of passive component, e.g., a resistor, capacitor, inductor, etc. In certain examples, the passive electronic device(s) 410 and/or the passive electronic component(s) 420 can collectively form an inductor-capacitor (LC) resonant circuit configured to operate as a notch filter or a band-pass filter. In other examples, the passive electronic device(s) 410 and/or the passive electronic component(s) 420 can collectively form a resistor-capacitor (RC) circuit configured to operate as any of the aforementioned types of filters. These integrated filters are particularly advantageous for noise-sensitive audio and radio frequency applications, and in some cases can reduce noise emissions a by up to 5 dBm, 10 dBm, or 15 dBm. The filters may also help to greatly reduce crosstalk noise inside a multi-chip module (MCM).

Beneficially, the disclosed embodiments can enable the package 100/400 to operate at high operational frequencies (e.g., radio frequencies up to and including VHF, UHF, and EHF) with reduced signal losses as compared to conventional substrates such as PCBs. Passive devices 410 (such as filters, e.g., high and low pass filters or notch and band-pass filters) can be patterned in the interposer 110, which can provide compact and low cost electrical functionality to improve the operation of the package. The disclosed embodiments can also provide a heat dissipation pathway for heat generated by the die 130. Moreover, providing the encapsulating material 150 over portions of both the die 130 and the interposer 110 can provide improved protection for the package 100 as compared to conventional packages. In some embodiments, the glass substrate can be patterned to set a clock frequency so that the interposer 110 can serve as a high pass or low pass filter. Bypass vias 115 and passive devices 410/420 can interact with the signals to condition and/or filter the signals. The illustrated packages 100/400 can operate at high frequencies with low insertion loss.

Reference throughout this specification to "some embodiments" or "an embodiment" means that a particular feature, structure, element, act, or characteristic described in connection with the embodiment is included in at least one embodiment. Thus, appearances of the phrases "in some embodiments" or "in an embodiment" in various places throughout this specification are not necessarily all referring to the same embodiment and may refer to one or more of the same or different embodiments. Furthermore, the particular features, structures, elements, acts, or characteristics may be combined in any suitable manner (including differently than shown or described) in other embodiments. Further, in various embodiments, features, structures, elements, acts, or characteristics can be combined, merged, rearranged, reordered, or left out altogether. Thus, no single feature, structure, element, act, or characteristic or group of features, structures, elements, acts, or characteristics is necessary or required for each embodiment. All possible combinations and subcombinations are intended to fall within the scope of this disclosure.

As used in this application, the terms "comprising," "including," "having," and the like are synonymous and are used inclusively, in an open-ended fashion, and do not exclude additional elements, features, acts, operations, and so forth. Also, the term "or" is used in its inclusive sense (and not in its exclusive sense) so that when used, for example, to connect a list of elements, the term "or" means one, some, or all of the elements in the list.

Similarly, it should be appreciated that in the above description of embodiments, various features are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that any claim require more features than are expressly recited in that claim. Rather, inventive aspects lie in a combination of fewer than all features of any single foregoing disclosed embodiment.

The foregoing description sets forth various example embodiments and other illustrative, but non-limiting, embodiments of the inventions disclosed herein. The description provides details regarding combinations, modes, and uses of the disclosed inventions. Other variations, combinations, modifications, equivalents, modes, uses, implementations, and/or applications of the disclosed features and aspects of the embodiments are also within the scope of this disclosure, including those that become apparent to those of skill in the art upon reading this specification. Additionally, certain objects and advantages of the inventions are described herein. It is to be understood that not necessarily all such objects or advantages may be achieved in any particular embodiment. Thus, for example, those skilled in the art will recognize that the inventions may be embodied or carried out in a manner that achieves or optimizes one advantage or group of advantages as taught herein without necessarily achieving other objects or advantages as may be taught or suggested herein. Also, in any method or process disclosed herein, the acts or operations making up the method or process may be performed in any suitable sequence and are not necessarily limited to any particular disclosed sequence.

There follows a list of numbered features defining particular embodiments of the disclosure. Where a numbered feature refers to one or more previous numbered features then those features should be considered in combination.
1. An integrated device package comprising:
   a glass interposer having one or more conductive vias extending through the glass interposer from a top side of the glass interposer to a bottom side of the glass interposer, the bottom side of the glass interposer comprising one or more contact pads;
   an integrated device die mounted and electrically connected to the top side of the glass interposer; and
   an encapsulating material disposed over at least a side surface of the glass interposer, a portion of the top side of the glass interposer, and a side surface of the integrated device die.
2. The integrated device package of feature 1, wherein the glass interposer comprises borosilicate glass.
3. The integrated device package of any of the preceding features, wherein the glass interposer comprises one or more passive devices configured to serve as a first electrical filter, and wherein the integrated device die comprises circuitry configured to serve as a second electrical filter.
4. The integrated device package of any of the preceding features, further comprising one or more passive electronic components mounted to the glass interposer.
5. The integrated device package of any of the preceding features, further comprising one or more solder balls connected to the one or more contact pads on the bottom side of the glass interposer.
6. The integrated device package of any of the preceding features, wherein the encapsulating material is disposed over a top side of the integrated device die.
7. The integrated device package of any of the preceding features, wherein a top side of the integrated device die is exposed through the encapsulating material.
8. The integrated device package of feature **Error! Reference source not found.**, further comprising a heat slug disposed on the exposed top side of the integrated device die and on an upper surface of the encapsulating material.
9. The integrated device package of any of the preceding features, wherein the encapsulating material comprises an organic molding compound.
10. An integrated device package comprising:
   an interposer having one or more conductive vias extending through the interposer from a top side of the interposer to a bottom side of the interposer, the interposer comprising one or more passive devices configured to serve as a first electrical filter; and
   an integrated device die mounted and electrically connected to the top side of the interposer, the integrated device die comprising circuitry configured to serve as a second electrical filter.
11. The integrated device package of feature 7, further comprising an encapsulating material, wherein the interposer and the integrated device die are at least partially embedded in the encapsulating material.
12. The integrated device package of feature 7 or 11, wherein the interposer is composed of a material having a loss tangent of less than 0.02 at 10 GHz.
13. The integrated device package of feature 9, wherein the interposer is composed of a glass material.
14. The integrated device package of feature 11, 12, or 13, wherein a top side of the integrated device die is exposed through the encapsulating material.
15. The integrated device package of feature 10, further comprising a heat slug disposed on the exposed top side of the integrated device die and on an upper surface of the encapsulating material.
16. The integrated device package of any of features 11 15, wherein the encapsulating material comprises an organic molding compound.
17. A method of forming an integrated device package, the method comprising:
   providing an interposer having one or more conductive vias and one or more passive devices configured to serve as a first electrical filter;
   forming a first plurality of conductive pads on one side of the interposer;
   mounting an integrated device die to the first plurality of conductive pads, the integrated device die comprising circuitry configured to serve as a second electrical filter; and
   depositing an encapsulating material over the interposer and the integrated device die.
18. The method of feature 17, further comprising:
   forming a second plurality of conductive pads on either side of the interposer; and
   providing solder on the second plurality of conductive pads for mounting the integrated device package.
19. The method of feature 17 or 18, further comprising mounting a heat slug or a heat sink to an exterior surface of the integrated device package.
20. The method of any of features 17 to 19, further comprising removing an excess portion of the encapsulating material to provide a planar exterior surface of the integrated device package, wherein removing the excess portion of the encapsulating material is performed by grinding or laser ablation.

## Claims

1. An integrated device package comprising:
a glass interposer having one or more conductive vias extending through the glass interposer from a top side of the glass interposer to a bottom side of the glass interposer, the bottom side of the glass interposer comprising one or more contact pads;
an integrated device die mounted and electrically connected to the top side of the glass interposer; and
an encapsulating material disposed over at least a side surface of the glass interposer, a portion of the top side of the glass interposer, and a side surface of the integrated device die.

2. The integrated device package of Claim 1, wherein the glass interposer comprises borosilicate glass.

3. The integrated device package of any of the preceding Claims, wherein the glass interposer comprises one or more passive devices configured to serve as a first electrical filter, and wherein the integrated device die comprises circuitry configured to serve as a second electrical filter.

4. The integrated device package of any of the preceding Claims, further comprising one or more passive electronic components mounted to the glass interposer.

5. The integrated device package of any of the preceding Claims, further comprising one or more solder balls connected to the one or more contact pads on the bottom side of the glass interposer.

6. The integrated device package of any of the preceding Claims, wherein the encapsulating material is disposed over a top side of the integrated device die.

7. An integrated device package comprising:
an interposer having one or more conductive vias extending through the interposer from a top side of the interposer to a bottom side of the interposer, the interposer comprising one or more passive devices configured to serve as a first electrical filter; and
an integrated device die mounted and electrically connected to the top side of the interposer, the integrated device die comprising circuitry configured to serve as a second electrical filter.

8. The integrated device package of Claim 7, further comprising an encapsulating material, wherein the interposer and the integrated device die are at least partially embedded in the encapsulating material.

9. The integrated device package of Claim 7 or 8, wherein the interposer is composed of a material having a loss tangent of less than 0.02 at 10 GHz, wherein optionally the interposer is composed of a glass material.

10. The integrated device package of any of the preceding claims, wherein a top side of the integrated device die is exposed through the encapsulating material, the device package optionally further comprising a heat slug disposed on the exposed top side of the integrated device die and on an upper surface of the encapsulating material.

11. The integrated device package of any of the preceding claims wherein the encapsulating material comprises an organic molding compound.

12. A method of forming an integrated device package, the method comprising:
providing an interposer having one or more conductive vias and one or more passive devices configured to serve as a first electrical filter;
forming a first plurality of conductive pads on one side of the interposer;
mounting an integrated device die to the first plurality of conductive pads, the integrated device die comprising circuitry configured to serve as a second electrical filter; and
depositing an encapsulating material over the interposer and the integrated device die.

13. The method of claim 12, further comprising:
forming a second plurality of conductive pads on either side of the interposer; and
providing solder on the second plurality of conductive pads for mounting the integrated device package.

14. The method of claim 12 or 13, further comprising mounting a heat slug or a heat sink to an exterior surface of the integrated device package.

15. The method of any of claims 12 to 14, further comprising removing an excess portion of the encapsulating material to provide a planar exterior surface of the integrated device package, wherein removing the excess portion of the encapsulating material is performed by grinding or laser ablation.
